# DEMANDE DE BREVET EUROPEEN

(11) **EP 1 010 985 A1**
(43) Date de publication de la demande: **21.06.2000**
(21) Numéro de dépôt: 99403039.3
(22) Date de dépôt: 06.12.1999
(51) Int. Cl.: G01R 23/20

(54) **Procédé de détection des niveaux de perturbations harmoniques d'un reseau électrique et son dispositif**

(30) Priorité: 07.12.1998 FR 9815403
(71) Demandeur: Mougeot, François, 21600 Longvic (FR)
(72) Inventeur: Mougeot, François, 21600 Longvic (FR)
(74) Mandataire: Bruder, Michel

(57) **Abrégé**

La présente invention concerne un procédé pour la détection des niveaux de perturbations harmoniques d'un réseau électrique, par exemple triphasé, comprenant une étape de prélèvement d'une information analogique de la tension dudit réseau électrique et un ajustement au niveau requis de l'information tension sans modification de ses composantes harmoniques, remarquable en ce que le procédé consiste au moins dans les étapes suivantes se succédant dans l'ordre ;
a) discrimination, en référence à une fréquence médiane, des informations de fréquence contenues dans l'information tension d'une part, en une information du type tension fondamentale V₁ dans les basses fréquences et d'autre part, en une information du type tension harmonique V₂ dans les hautes fréquences qui contient, en résiduel, une fraction de la tension fondamentale,
b) traitement des informations du type tension fondamentale V₁ et du type tension harmonique V₂ indépendamment l'une de l'autre, successivement et dans l'ordre, par une adaptation d'amplitude, une élévation au carré du signal, une intégration et un lissage,
c) comparaison des informations traitées.

L'invention concerne également un dispositif mettant en oeuvre le procédé.

## Description

La présente invention concerne un procédé de détection des niveaux de perturbations harmoniques d'un réseau électrique et son dispositif. Le procédé et son dispositif sont particulièrement applicables à la détection des niveaux de perturbations harmoniques sur un réseau électrique notamment triphasé ou sur un réseau autonome du type groupe électrogène par exemple.

D'une manière générale, les réseaux électriques délivrent un courant électrique à une fréquence donnée, par exemple, 50 Hertz en France, toutefois, il est bien connu que les réseaux délivrent également des courants à des fréquences harmoniques, dus à nombre d'appareils électroniques raccordés au réseau qui génèrent de tels courants, dits courants harmoniques, qui se répercutent sur le réseau entre tous les utilisateurs, accentués par des phénomènes d'amplification par résonance liés aux caractéristiques du réseau.

Les producteurs, les distributeurs et les utilisateurs de l'énergie électrique estiment que les risques de perturbations et de dommages des appareils électriques ou électroniques raccordés au réseau sont faibles si l'on se maintient à un taux de distorsion harmonique en tension inférieur à cinq pour cent. Par contre un taux de distorsion harmonique en tension supérieur à huit pour cent induit un risque majeur de disfonctionnement ou de détérioration des nombreux appareils électriques ou électroniques branchés sur ledit réseau.

A cet effet, une solution classique de correction du réseau consiste à monter des selfs dites anti-harmoniques en batterie sur les condensateurs de compensation. Il s'agit en fait de redimensionner dans un premier temps les condensateurs, c'est à dire de supprimer les condensateurs déjà existants et de les remplacer par des condensateurs adaptés, couplés avec des selfs anti-harmoniques afin de donner au réseau une caractéristique essentiellement selfique au-delà d'un certain rang harmonique et atténuer, de ce fait, les courants harmoniques.

Le principal avantage de cette correction est d'atténuer automatiquement les courants harmoniques sur le réseau sans avoir à se préoccuper de la présence effective de tels courants harmoniques.

Un inconvénient de cette solution corrective est de nécessiter beaucoup d'espace pour sa réalisation car elle requiert plusieurs armoires électriques souvent encombrantes.

Un autre inconvénient de cette correction est le coût élevé que représente sa mise en oeuvre, notamment lorsqu'il s'agit d'un réseau autonome du type groupe électrogène ; par ailleurs cette solution ne permet pas de visualiser le phénomène et il n'est donc pas possible d'ajuster le dispositif de correction en fonction du taux de courant harmonique réellement présent sur le réseau.

A cet égard, on a conçu des détecteurs des niveaux de perturbations harmoniques ; c'est, par exemple, le cas du brevet anglais GB 1 169 706. Le détecteur est constitué d'un filtre accepteur isolant la composante fondamentale et d'un filtre réjecteur isolant les composantes harmoniques de l'information tension préalablement prélevée sur le réseau électrique et ajustée au niveau requis. Le filtre accepteur, accordé sur la fréquence fondamentale, est constitué d'une capacité et d'une inductance montées en série et le filtre récepteur, également accordé sur la fréquence fondamentale, est constitué d'une capacité et d'une inductance montées en parallèle. L'information en tension est transformée par l'intermédiaire d'un transformateur de courant, après son passage dans le filtre accepteur ou dans le filtre réjecteur, soit en une information en intensité correspondant à la tension fondamentale soit en une information en intensité correspondant aux harmoniques. Les informations en intensité fondamentale et en intensité harmonique sont ensuite comparées dans un comparateur pour mesurer le taux de distorsion harmonique qui, s'il est supérieur à 5%, déclenche un dispositif d'alarme.

Ce dispositif, et par conséquent ce procédé, présente l'inconvénient de nécessiter l'accord du circuit accepteur et du circuit réjecteur sur la même fréquence fondamentale, ce qui entraîne des résultats aléatoires en cas de dérive soit des caractéristiques des composantes, soit de la valeur de la fréquence fondamentale qui n'est pas nécessairement stable sur le réseau électrique.

L'un des buts de l'invention est donc de palier ces inconvénients en proposant un procédé de détection du niveau de perturbations harmoniques d'un réseau électrique, par exemple triphasé et prendre, le cas échéant, les mesures correctrices adaptées pour y remédier.

A cet égard et conformément à l'invention, le procédé pour la détection du niveau de perturbations harmoniques d'un réseau électrique, par exemple triphasé, comporte une première étape de prélèvement d'une information analogique de la tension d'un réseau électrique, puis, afin de rendre les informations en tension initialement prélevées exploitables par les circuits électroniques, on effectue un ajustement au niveau requis de l'information tension sans modification de ses composantes harmoniques. Il est alors envisageable d'utiliser des circuits électroniques numériques pour traiter les informations ou bien mettre en place un système de filtres dits sélectifs afin d'éliminer l'information du type fondamentale puis de mesurer la valeur de la tension harmonique. De tels procédés sont particulièrement coûteux et difficiles à mettre en place, de plus la mesure de la tension harmonique n'est pas nécessaire. Conformément à l'invention, le procédé est remarquable en ce que l'on effectue, en référence à une fréquence médiane, une discrimination des informations de fréquence contenues dans l'information tension d'une part en une information du type tension fondamentale dans les basses fréquences et d'autre part, en une information du type tension harmonique dans les hautes fréquences qui contient aussi la tension fondamentale résiduelle, puis effectuer un traitement des informations du type tension fondamentale et du type tension harmonique, et enfin une comparaison des informations traitées, afin de visualiser le niveau de perturbations harmoniques.

Pour le traitement des informations du type tension fondamentale et du type tension harmonique, après l'étape de discrimination, il est également envisageable d'utiliser un circuit électronique numérique qui traite les informations simultanément. Un tel procédé reste sensible aux variations de courant du réseau électrique, c'est pourquoi on préfère traiter les informations du type tension fondamentale et du type tension harmonique indépendamment l'une de l'autre de telle sorte que l'on puisse effectuer, par la suite, une comparaison de l'image en valeur efficace de la tension fondamentale et de l'image en valeur efficace de la tension harmonique permettant ainsi une insensibilité aux variations de courant.

A cet égard, on effectue en premier lieu une adaptation d'amplitude, puis une élévation au carré du signal, et enfin une intégration et un lissage pour chacune des tensions de type fondamentale et de type harmonique.

Finalement, on effectue une comparaison des informations du type tension fondamentale et du type tension harmonique qui consiste en une analyse des écarts par seuil afin de visualiser le niveau de perturbations harmoniques présentes sur le réseau électrique.

Selon une caractéristique secondaire du procédé selon l'invention, dans l'étape, en référence à une fréquence médiane, de discrimination des informations de fréquence contenues dans l'information tension d'une part en une information du type tension fondamentale dans les basses fréquences et d'autre part, en une information de type tension harmonique dans les hautes fréquences, pour l'application à un réseau électrique triphasé dont la fréquence est de 50 Hertz, la fréquence médiane de référence est la fréquence correspondant à des harmoniques autour du rang trois et demi, c'est à dire autour de 175 Hertz, afin d'atténuer notamment les interférences dues aux fréquences dites de déclenchement des appareils électriques qui correspondent, en France, à des harmoniques de rang trois et demi.

Un autre but de l'invention concerne un dispositif, mettant en oeuvre ledit procédé, pour la détection du niveau de perturbations harmoniques d'un réseau électrique, par exemple triphasé, comportant un diviseur de tension pour le prélèvement et l'ajustement d'une information de la tension sur ledit réseau électrique ; ce dispositif est remarquable en ce qu'il comprend au moins un transformateur de tension pour l'alimentation des différents circuits électroniques, un filtre passe-bas et un filtre passe-haut, montés en parallèle pour effectuer une discrimination, en référence à une fréquence médiane, des informations de fréquence contenues dans l'information tension en une information du type tension fondamentale dans les basses fréquences et en une information de type tension harmonique dans les hautes fréquences, deux circuits de traitement de ces informations comprenant chacun respectivement, et en série, un adaptateur d'amplitude, un circuit multiplieur et un intégrateur de courant, un circuit comparateur effectuant une analyse des écarts par seuil des informations prises aux bornes des circuits de traitement des informations, une unité de traitement logique et des diodes de signalisation pour indiquer le niveau de perturbations harmoniques, avantageusement contenus dans un boîtier.

Selon une caractéristique essentielle du dispositif conforme à l'invention, le circuit passe-bas ou le circuit passe-haut est un circuit électronique tel que comprenant, notamment, des amplificateurs opérationnels et une alimentation indépendante.

D'autres avantages et caractéristiques ressortiront mieux de la description qui va suivre, de plusieurs variantes d'exécution, données à titre d'exemples non limitatifs, du procédé et du dispositif le mettant en oeuvre conformément à l'invention destiné à détecter les niveaux de perturbations harmoniques d'un réseau électrique, par exemple triphasé, en référence aux dessins annexés sur lesquels :
- la figure 1 représente le schéma partiel d'une première partie du dispositif selon l'invention comportant le réseau électrique triphasé, le diviseur de tension, les circuits passe-bas et passe-haut et l'alimentation auxiliaire.
- la figure 2 représente le schéma partiel d'une deuxième partie du dispositif comportant le circuit de traitement des informations du type tension fondamentale et du type tension harmonique.
- la figure 3 représente le schéma partiel d'une troisième partie du dispositif comportant le circuit permettant la visualisation du niveau de perturbations harmoniques.

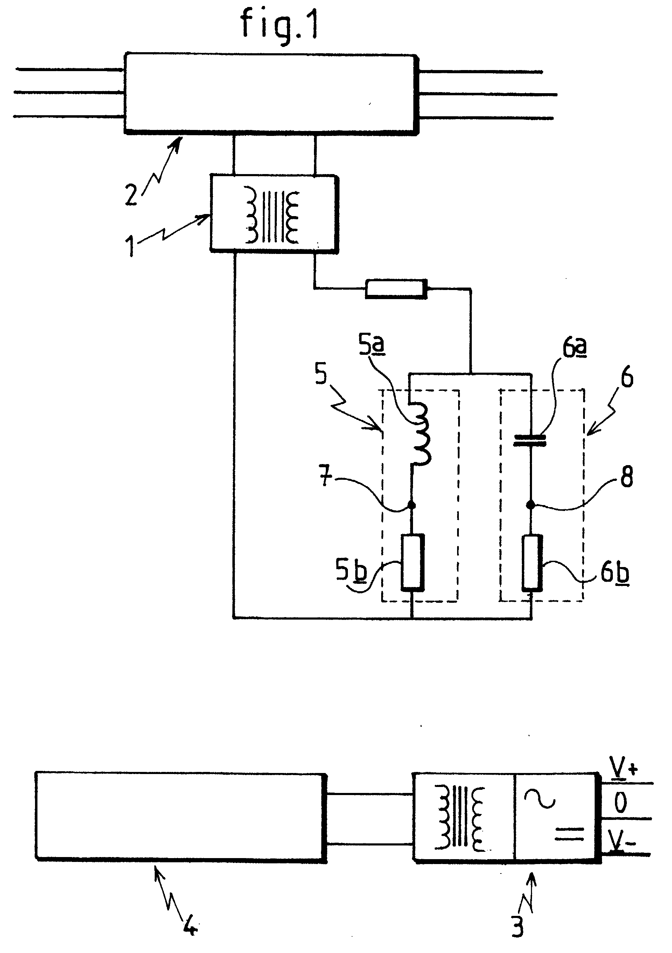

Le dispositif de détection de niveau des perturbations harmoniques d'un réseau électrique triphasé qui est représenté sur les figures 1 à 3 comprend un transformateur de tension 1 qui à pour fonction de prélever les informations, qui sont des informations analogiques, en tension sur le réseau d'alimentation électrique triphasé 2. Le transformateur de tension 1 a ses composants dimensionnés de telle sorte qu'il a comme principale caractéristique de présenter une faible saturation des signaux à des fréquences élevées ce qui permet de conserver l'information du type tension harmonique. Ce transformateur de tension 1, de préférence avec isolement galvanique pour des raisons évidentes de sécurité, outre sa fonction de capteur, a également une fonction de diviseur de tension pour rendre les informations en tension prélevées exploitables par les circuits électroniques.

Selon une disposition particulière de l'invention, la fonction de diviseur peut être assurée par un limiteur résistif qui n'est pas représenté sur la figure 1, néanmoins il sera préféré le transformateur de tension 1 en raison des dissipations élevées et de l'encombrement intempestif qu'un limiteur résistif procure.

Le dispositif de détection de niveau des perturbations harmoniques d'un réseau électrique triphasé comprend, par ailleurs, un transformateur 3, branché sur un réseau monophasé 4, d'alimentation auxiliaire afin de fournir en courant l'ensemble des circuits électroniques qui seront décrits par la suite. Le dispositif comprend également un circuit passe-bas 5 et un circuit passe-haut 6 montés en parallèle formant un filtre. Le circuit passe-bas 5 est constitué par une inductance 5a montée en série avec une résistance 5b. Quant au circuit passe-haut 6, il est constitué par une capacité 6a montée en série avec une résistance 6b.

Selon une variante particulièrement avantageuse de l'invention, le circuit passe-bas 5 est un circuit électronique comprenant notamment des amplificateurs opérationnels et une source d'alimentation indépendante, non représentés sur la figure 1, permettant de reproduire les caractéristiques d'une inductance précise qu'il serait peu aisé d'obtenir avec un composant classique. En effet, il est difficile, au moyen d'une inductance 5a classique et d'un condensateur 6a, d'obtenir un niveau d'accord du filtre, composé du circuit passe-bas 5 et du circuit passe-haut 6, suffisant pour opérer une discrimination, en référence à une fréquence médiane qui est de préférence autour de 175 Hertz en France, plus ou moins 5%, pour un réseau électrique triphasé, ce qui correspond à un niveau harmonique autour du rang trois et demi des informations de fréquences contenues dans l'information tension fournie par le transformateur de tension 1 ; c'est pourquoi il est particulièrement avantageux d'utiliser un circuit électronique équivalent au circuit passe-bas 5. La fréquence médiane de référence correspond, de préférence, à un niveau harmonique autour du rang trois et demi pour atténuer les informations dues aux fréquences de déclenchement des appareils électriques qui correspondent également à des harmoniques de rang trois et demi en France.

A cet égard, on cherchera une fréquence d'accord du filtre, composé du circuit passe-bas 5 et du circuit passe-haut 6, correspondant à ladite fréquence médiane de telle sorte que les informations du type tension fondamentale soient atténuées et que les informations du type tension harmonique soient amplifiées.

Il va de soi que le niveau d'accord, ou fréquence d'accord, dudit filtre dépendra des caractéristiques des composants utilisés et de l'application envisagée.

Selon une autre disposition particulière de l'invention, le circuit passe-haut 6 est essentiellement composé d'un circuit électronique comprenant, notamment, des amplificateurs opérationnels ainsi qu'une alimentation indépendante, non représentés sur la figure 1, permettant de reproduire les caractéristiques d'une capacitance, afin d'obtenir le niveau d'accord dudit filtre nécessaire à la discrimination, en référence à une fréquence médiane, des informations de fréquences contenues dans l'information tension fournie par le transformateur de tension 1.

Il est bien évident que les circuits passe-bas 5 et passe-haut 6 peuvent être tous deux des circuits électroniques tels que décrits précédemment.

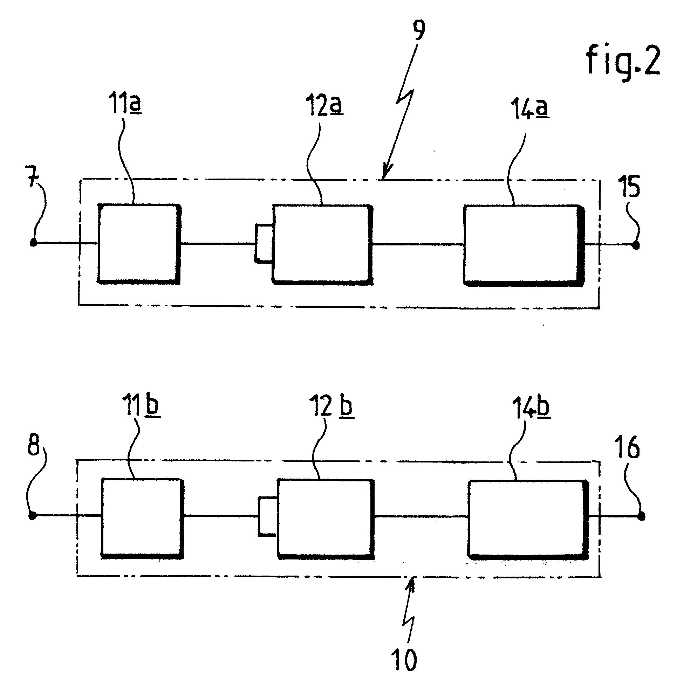

Le dispositif comprend deux points de prélèvement 7 et 8 respectivement des tensions V₁ et V₂ qui sont traitées par les deux circuits respectifs 9 et 10 représentés sur la figure 2. Les tensions V₁ et V₂ correspondent respectivement à une information du type tension fondamentale et à une information du type tension harmonique. Le circuit 9 relié au point de prélèvement 7 comprend un amplificateur 11a de coefficient d'amplification k₁, un circuit multiplieur 12a, et un circuit intégrateur 14a montés en série pour traiter le signal V₁. Quant au circuit 10 relié au point de prélèvement 8, il comprend un amplificateur 11b de coefficient d'amplification k₂, un circuit multiplieur 12b et un circuit intégrateur 14b montés en série pour traiter le signal V₂. Les circuits amplificateurs 11a et 11b, dont les coefficients respectifs k₁ et k₂ sont choisis entre zéro et un nombre quelconque, suivant les caractéristiques du réseau, permettent d'obtenir la même amplitude, à la fréquence fondamentale, du signal pour chacune des tensions prélevées V₁ et V₂ ; les signaux obtenus, après le passage dans les amplificateurs 11a et 11b, sont respectivement V'₁ et V'₂. Ces signaux sont ensuite traités par les multiplieurs respectifs 12a, et 12b qui sont configurés de telle sorte que l'on obtienne à leurs sorties le carré des signaux entrant, c'est-à-dire (V'₁)² et (V'₂)² afin de permettre l'extraction par les intégrateurs 14a et 14b d'une valeur moyenne non nulle desdits signaux et qui, finalement délivrent à leurs sorties respectives 15 et 16 l'image en valeur efficace de la tension fondamentale V''₁ et l'image en valeur efficace de la tension harmonique V''₂ qui sont des valeurs élevées au carré.

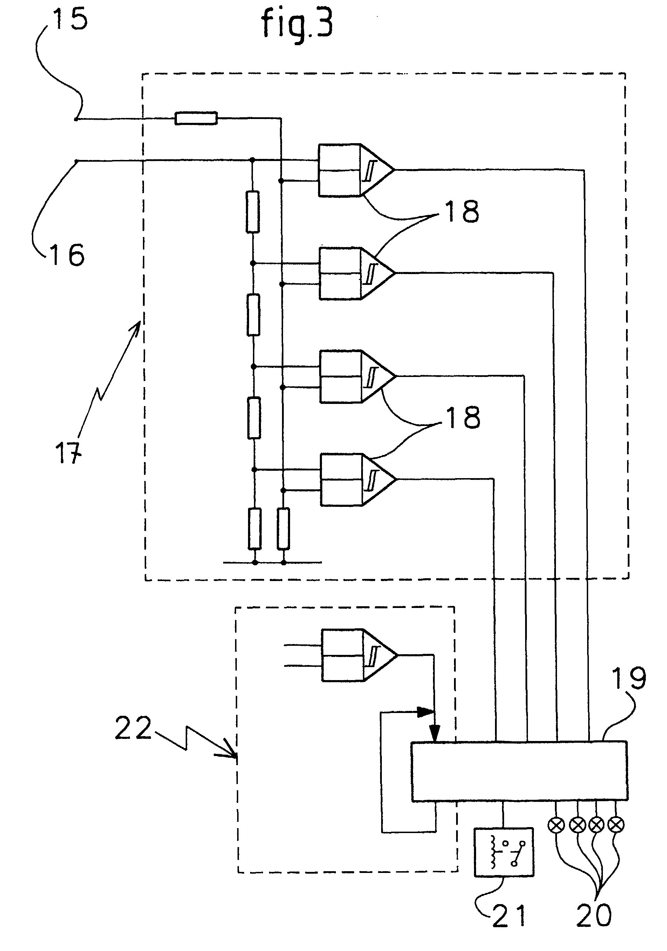

Le signal V''₁, à la sortie 15 du circuit 9, et le signal V''₂, à la sortie 16 du circuit 10, sont ensuite comparés grâce à un circuit comparateur 17 représenté à la figure 3.

Le circuit comparateur 17 comporte des comparateurs à hystérésis 18, de préférence à hystérésis non nul, au nombre de quatre dans cet exemple de réalisation, montés en parallèle et reliés à une unité de traitement logique 19. Les comparateurs à hystérésis 18 traitent les informations analogiques en tension V''₁ et V''₂, puis transmettent des informations binaires, du type 0 et 1, à l'unité de traitement logique 19 qui comprend des diodes luminescentes 20 permettant de visualiser le niveau de perturbations harmoniques. Chaque comparateur à hystérésis 18 effectue une comparaison de l'image en valeur efficace de la tension fondamentale V''₁, qui est la tension de référence, avec l'image en valeur efficace de la tension harmonique V''₂, qui comprend la tension fondamentale et la tension résiduelle, par seuils. Dès lors que le seuil de l'un des comparateurs à hystérésis 18 est atteint l'unité de traitement logique 19 reçoit l'information, la traite, puis active la diode luminescente 20 correspondant au seuil atteint permettant ainsi une visualisation du niveau de perturbations harmoniques sur le réseau électrique 2, par exemple triphasé.

A cet égard, le premier seuil correspond à une situation normale, c'est-à-dire que le signal contient un taux de distorsion en tension compris entre 0 et 2%, le second seuil correspond à une situation de perturbation dont le niveau reste acceptable, c'est à dire un taux de distorsion entre 2 et 5%, le troisième seuil correspond au seuil critique d'acceptabilité, c'est à dire un taux de distorsion compris entre 5 et 8% et le dernier seuil correspond à une situation de perturbation dont le niveau implique des risques de dommage ou de disfonctionnement, c'est à dire un taux de distorsion supérieur à 8%.

L'unité de traitement logique 19 est, par ailleurs, alimentée par le transformateur 3, représenté à la figure 1 ; il comprend également un relais de défaut 21, permettant, notamment, d'activer un organe de signalisation ou un dispositif de correction, non représentés sur la figure 3, et un circuit 22 de mise en défaut. Le circuit 22 de mise en défaut comprend essentiellement un comparateur logique 18 à hystérésis qui compare l'image de la tension fondamentale V''₁ avec un minima de tension admissible préétabli afin d'activer le circuit 22 de mise en défaut si ledit minima de tension admissible n'est pas atteint.

Il est bien évident qu'un tel dispositif comprenant de tels circuits électroniques est avantageusement contenu dans un boîtier du type appareillage intégrable en tableau permettant un encliquetage sur un rail standardisé.

## Revendications

1. Procédé pour la détection des niveaux de perturbations harmoniques d'un réseau électrique, par exemple triphasé, comprenant une étape de prélèvement d'une information analogique de la tension dudit réseau électrique et un ajustement au niveau requis de l'information tension sans modification de ses composantes harmoniques, **caractérisé** en ce que le procédé consiste au moins dans les étapes suivantes se succédant dans l'ordre :
a) discrimination, en référence à une fréquence médiane, des informations de fréquence contenues dans l'information tension d'une part, en une information du type tension fondamentale V₁ dans les basses fréquences et d'autre part, en une information du type tension harmonique V₂ dans les hautes fréquences qui contient, en résiduel, une fraction de la tension fondamentale,
b) traitement des informations du type tension fondamentale V₁ et du type tension harmonique V₂ indépendamment l'une de l'autre, successivement et dans l'ordre, par une adaptation d'amplitude, une élévation au carré du signal, une intégration et un lissage,
c) comparaison des informations traitées.

2. Procédé selon la revendication 1 **caractérisé** en ce que l'étape c) de comparaison des informations du type tension fondamentale V₁ et du type tension harmonique V₂ consiste en une analyse des écarts par seuil.

3. Procédé selon l'une quelconque des revendications précédentes **caractérisé** en ce que dans l'étape a) de discrimination, pour l'application à un réseau électrique triphasé dont la fréquence est de 50 Hertz, la fréquence médiane de référence est la fréquence correspondant à des harmoniques autour du rang trois et demi pour atténuer les informations correspondant aux fréquences dites de déclenchement des appareils électriques.

4. Dispositif mettant en oeuvre le procédé selon l'une quelconque des revendications 1 à 3 pour la détection du niveau de perturbations harmoniques d'un réseau électrique, par exemple triphasé, comprenant un diviseur de tension (1) pour le prélèvement et l'ajustement d'une information de la tension sur ledit réseau électrique **caractérisé** en ce qu'il comprend au moins un transformateur de tension (3) pour l'alimentation des différents circuits électroniques, un filtre passe-bas (5) et un filtre passe-haut (6), montés en parallèle pour effectuer une discrimination, en référence à une fréquence médiane, des informations de fréquence contenues dans l'information tension en une information du type tension fondamentale V₁ dans les basses fréquences et en une information de type tension harmonique V₂ dans les hautes fréquences, deux circuits (9,10) de traitement de ces informations comprenant chacun respectivement, et en série, un adaptateur d'amplitude (11a,11b), un circuit multiplieur (12a,12b) et un intégrateur de courant (14a,14b), un circuit comparateur (17) effectuant une analyse des écarts par seuil des informations prises aux bornes des circuits (9,10) de traitement des informations, une unité de traitement logique (19) et des diodes de signalisation (20) pour indiquer le niveau de perturbations harmoniques, avantageusement contenus dans un boîtier.

5. Dispositif selon la revendication 4 **caractérisé** en ce que le circuit passe-bas (5) ou le circuit passe-haut (6) est un circuit électronique tel que comprenant, notamment, des amplificateurs opérationnels et une alimentation indépendante.

6. Dispositif selon la revendication 4 **caractérisé** en ce que le circuit passe-bas (5) et le circuit passe-haut (6) sont des circuits électroniques tels que comprenant notamment des amplificateurs opérationnels et une alimentation indépendante par circuit.

7. Dispositif selon l'une quelconque des revendications 4 à 6 **caractérisé** en ce que le circuit comparateur (17) est constitué de comparateurs à hystérésis (18) montés en parallèle.
